Europäisches Patentamt

(19) European Patent Office

Office européen des brevets

(11) Numéro de publication: **0 147 306**
**A2**

(12) ## DEMANDE DE BREVET EUROPEEN

(21) Numéro de dépôt: **84402633.6**

(22) Date de dépôt: **18.12.84**

(51) Int. Cl.⁴: **H 03 F 1/02**

(30) Priorité: **23.12.83 FR 8320680**

(43) Date de publication de la demande:
**03.07.85 Bulletin 85/27**

(84) Etats contractants désignés:
**DE GB IT NL**

(71) Demandeur: **THOMSON-CSF**
**173, Boulevard Haussmann**
**F-75379 Paris Cedex 08(FR)**

(72) Inventeur: **Cord'homme, Edmond**
**THOMSON-CSF SCPI 173 bld Haussmann**
**F-75379 Paris Cedex 08(FR)**

(74) Mandataire: **Desperrier, Jean-Louis et al,**
**THOMSON-CSF SCPI 173, Bld Haussmann**
**F-75379 Paris Cedex 08(FR)**

(54) **Amplificateur de puissance linéaire.**

(57) Dans cet amplificateur, comportant au moins un transistor bipolaire (1) de type classe B muni d'une électrode dite de commande, à laquelle est appliqué le signal à amplifier et de deux électrodes dites de transfert, sur l'une desquelles est obtenu le signal amplifié, et des moyens de polarisation (3) de ces transistors, les moyens de polarisation comportent un générateur (7) de signaux de polarisation variables par paliers, et des moyens (8) de commande de ce générateur, en fonction de l'amplitude du signal amplifié, en vue de maintenir à chaque instant la tension entre électrodes de transfert, en valeur absolue, de celui des transistors qui est conducteur à cet instant, au plus égale à une valeur limite $\Delta V$.

Application aux générateurs de signaux électriques.

**FIG.1**

EP 0 147 306 A2

1

## AMPLIFICATEUR DE PUISSANCE LINEAIRE

La présente invention concerne un amplificateur de puissance, linéaire.

Un tel amplificateur trouve notamment à s'appliquer dans l'étage de sortie de générateurs de signaux électriques de forme prédéterminée, qui peut être quelconque, dont la tension crête peut atteindre plusieurs centaines de volts, et ceci avec un rendement qui peut être supérieur à 90 % et un taux de distorsion très réduit, si nécessaire de l'ordre de 1 ‰.

Il est connu d'utiliser un amplificateur du type classe B fortement contre-réactionné pour obtenir un taux de distorsion très réduit du signal de sortie par rapport au signal d'entrée, mais son rendement est médiocre, environ 50 %. De plus, les transistors qui constituent les éléments actifs de l'amplificateur doivent respecter leur "aire de sécurité", c'est-à-dire fonctionner dans une zone limitée de leur réseau de sortie $I_C - V_{CE}$ (courant collecteur, tension collecteur-émetteur) dans laquelle la puissance dissipée (produit $I_C \cdot V_{CE}$) reste inférieure à une valeur limite $P_{max}$ à ne pas dépasser. Il s'ensuit que les transistors ne peuvent fournir leur courant de sortie maximum qu'avec des tensions de sortie faibles, soit 20V à 40V maximum. Pour obtenir des puissances élevées avec des tensions de sortie élevées, un amplificateur classe B classique ne peut pas être utilisé. Pour fournir la tension maximum désirée on pourrait additionner les tensions de sortie de plusieurs amplificateurs classe B classiques mais le rendement resterait médiocre.

On connaît par ailleurs (voir la demande de brevet français N° 80.00169 déposée au nom de la Demanderesse) des générateurs de signaux électriques de puissance élevée (plusieurs kilowatts) et à tension de sortie élevée, qui permettent d'obtenir en sortie un signal de forme prédéterminée avec un bon rendement. Pour cela on associe plusieurs circuits d'alimentation commandés par le signal à amplifier et fournissant chacun un créneau de tension dont la durée et la polarité dépendent de la forme d'onde à amplifier ; ces créneaux produisent dans une charge commune de sortie des courants qui en s'additionnant fournissent le signal amplifié.

Ce type d'amplificateur permet d'atteindre un très bon rendement, supérieur à 90 %. Le taux de distorsion obtenu est d'autant plus réduit que le nombre de circuits d'alimentation est plus élevé. Cependant, pour obtenir un faible taux de distorsion, de l'ordre de 1 ‰, le nombre de circuits d'alimentation serait prohibitif (plus de 100).

La présente invention a pour objet un amplificateur qui permet d'obtenir à la fois un taux de distorsion très réduit, et des puissances élevées avec des tensions de sortie élevées.

Dans l'amplificateur de puissance, linéaire, suivant l'invention, comportant au moins un transistor bipolaire de type classe B muni d'une électrode dite de commande à laquelle est appliquée le signal à amplifier, et de deux électrodes dites de transfert, sur l'une desquelles est obtenu le signal amplifié, et des moyens de polarisation de ce transistor, les moyens de polarisation comportent un générateur de signaux de polarisation variables par paliers, et des moyens de commande de ce générateur, en fonction de l'amplitude du signal amplifié, en vue de maintenir à chaque instant la tension entre électrodes de transfert, en valeur absolue, de celui des transistors qui est conducteur à cet instant, au plus égale à une valeur limite $\Delta V$.

Les objets et caractéristiques de la présente invention apparaîtront plus clairement à la lecture de la description suivante d'exemples de réalisation, faite en relation avec les dessins ci-annexés dans lesquels :

- la figure 1 est un schéma synoptique d'un amplificateur suivant l'invention, du type comportant un seul transistor classe B ;

- la figure 2 montre la forme de la tension de polarisation et de la tension de sortie de l'amplificateur représenté sur la figure 1, pour une tension à amplifier donnée ;

- la figure 3 est un schéma d'un premier mode de réalisation d'un amplificateur suivant l'invention, du type comportant deux transistors classe B ;

- la figure 4 montre la forme des tensions de polarisation des deux transistors et de la tension de sortie de l'amplificateur représenté sur la figure 3, pour une tension à amplifier donnée ;

- la figure 5 est un schéma d'un deuxième mode de réalisation d'un amplificateur suivant l'invention, du type comportant deux transistors classe B ;

- la figure 6 montre la forme des tensions de polarisation des deux transistors et de la tension de sortie de l'amplificateur représenté sur la figure 5, pour une tension à amplifier donnée ;

- les figures 7, 8 et 9 sont respectivement des schémas d'un troisième, d'un quatrième et d'un cinquième mode de réalisation d'un amplificateur suivant l'invention, du type comportant deux transistors classe B ;

- la figure 10 est un schéma d'un sixième mode de réalisation de l'amplificateur suivant l'invention, du type comportant un seul transistor classe B ;

- la figure 11 montre la forme de la tension de polarisation et de la tension de sortie de l'amplificateur représenté sur la figure 10, pour une tension à amplifier donnée.

Dans la suite de la description, on entend par électrode de commande d'un transistor la base de ce transistor, et par électrodes de transfert l'émetteur et le collecteur de ce transistor.

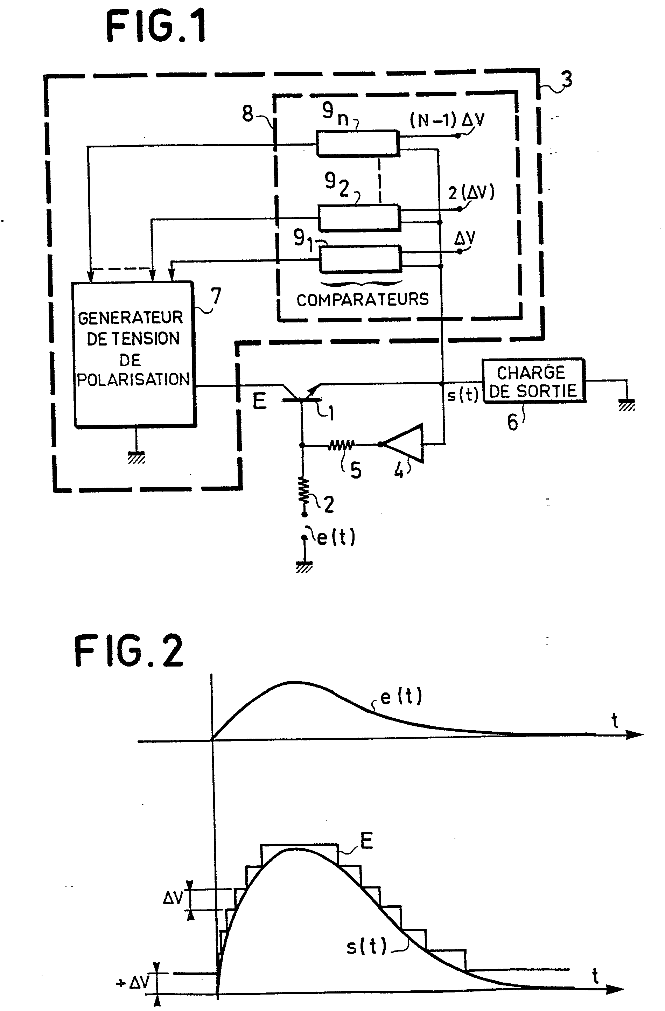

L'amplificateur représenté sur la figure 1 comporte un transistor bipolaire 1 du type classe B, par exemple un transistor du type NPN. La tension $e(t)$ à amplifier est appliquée à la base, ou électrode de commande, de ce transistor via une résistance 2.

Une tension de polarisation E, fournie par des moyens de polarisation 3, est appliquée au collecteur de ce transistor.

Ce transistor est contre-réactionné par un amplificateur inverseur à grand gain 4 dont l'entrée est reliée à l'émetteur, ou électrode de sortie, du transistor, et dont la sortie est reliée à la base via une résistance 5. La tension de sortie $s(t)$ est obtenue à l'émetteur du transistor 1. Une charge de sortie 6 est par ailleurs connectée à l'émetteur du transistor 1.

Le signal à amplifier $e(t)$ est référencé par rapport à la masse ; les moyens de polarisation 3 et la charge de sortie 6 sont également référencés par rapport à la masse.

Les moyens de polarisation 3 comportent un générateur 7 de tension de polarisation E variable par paliers de $\pm \Delta V$ à partir d'une valeur fixe $+ \Delta V$, et jusqu'à une valeur maximale $+ N(\Delta V)$, et des moyens 8 de commande du

4

générateur 7 pour obtenir une variation de $\pm \Delta V$ de la tension de polarisation E à la suite d'une variation correspondante de $\pm \Delta V$ de la tension de sortie s(t), de manière à maintenir à chaque instant la différence entre la tension de sortie s(t) et la tension de polarisation E, et, partant, la tension collecteur-émetteur $V_{CE}$ du transistor 1, au plus égale à $\Delta V$.

Les moyens 8 comportent un ensemble de N-1 comparateurs $9_n$ permettant de comparer la tension de sortie s(t) à chacune des N-1 tensions n($\Delta V$) (n variant de 1 à N-1).

Sur la figure 2 on a représenté un exemple de tension d'entrée à amplifier, e(t), de signe positif, ainsi que la tension de polarisation E et la tension de sortie amplifiée s(t). Au départ la tension de sortie s(t) est nulle, la tension de polarisation E est égale à la tension fixe $\Delta V$ et le transistor 1 est mis en conduction. Au bout d'un intervalle de temps, fonction de la forme du signal e(t), la tension de sortie s(t) devient égale à $\Delta V$. A ce moment là, la tension de sortie devenant égale à la tension de polarisation E, les moyens 8 commandent l'addition d'un échelon de tension $\Delta V$ à la tension de polarisation E, portant la tension au collecteur du transistor à $2 \Delta V$. La tension de sortie s(t) étant alors égale à $\Delta V$, la différence de tension $V_{CE}$ entre collecteur et émetteur du transistor 1 est au plus égale à $\Delta V$. Puis la tension de sortie s(t) augmente jusqu'à $2 \Delta V$ et à ce moment là les moyens 8 commandent l'addition d'un nouvel échelon $\Delta V$ à la tension de polarisation E, portant la tension au collecteur à $3 \Delta V$. Ce processus se poursuit tant que le signal e(t) augmente, la valeur maximum possible pour E étant N($\Delta V$). Après le maximum, lorsque la tension diminue, les moyens 8 permettent de retrancher les échelons de tension $\Delta V$. Ainsi, on voit sur la figure 2 qu'à aucun moment la différence entre tension de sortie s(t) et tension de polarisation E ne dépasse $\Delta V$. Ceci garantit donc le fonctionnement du transistor dans son aire de sécurité.

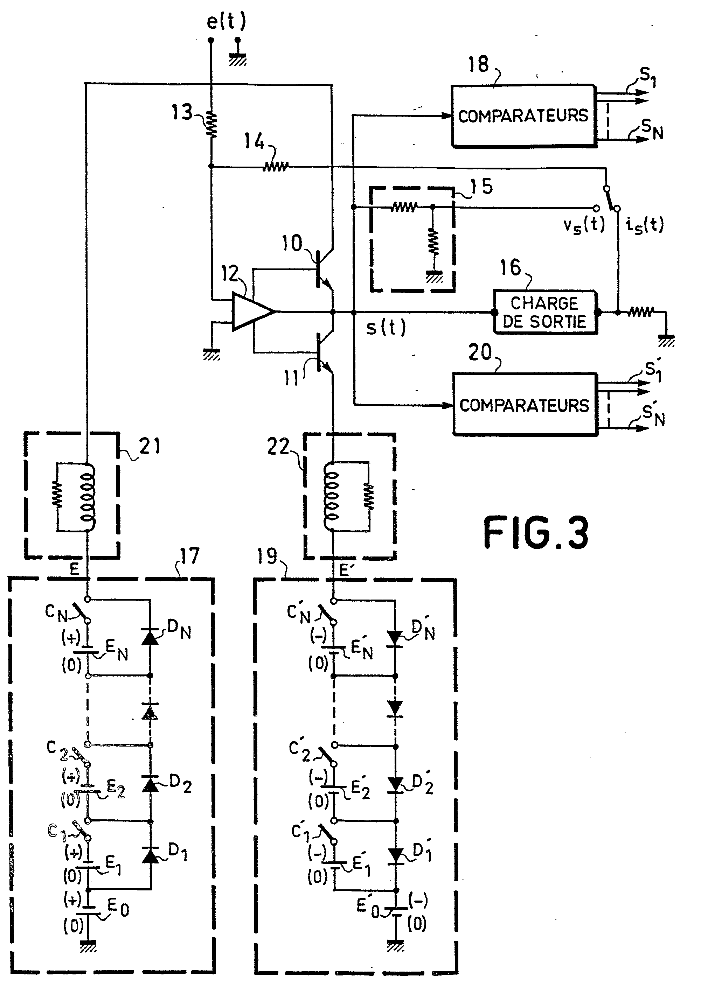

L'amplificateur représenté sur la figure 3 comporte deux transistors du type classe B, 10 et 11, du type NPN par exemple. La base, ou électrode de commande, de ces deux transistors est reliée à la sortie d'un amplificateur 12 à très grand gain dont l'entrée reçoit d'une part le signal à amplifier e(t), via une résistance 13, d'autre part un signal de contre-réaction, via une résistance 14. Le signal à amplifier e(t) peut dans ce cas être un signal

5

alternatif. Le signal de contre-réaction est soit le courant de sortie $i_s(t)$, soit la tension $v_s(t)$ obtenue en sortie d'un diviseur de tension 15 qui reçoit en entrée la tension de sortie $s(t)$.

L'émetteur du transistor 10 et le collecteur du transistor 11, reliés entre eux, constituent l'électrode de sortie commune sur laquelle est obtenue la tension de sortie $s(t)$ et à laquelle est connectée une charge de sortie 16.

Une tension de polarisation E est appliquée au collecteur du transistor 10. La tension de polarisation E, fournie par un générateur 17, varie graduellement, par paliers de $\pm \Delta V$, à partir d'une valeur fixe $+\Delta V$ et jusqu'à une valeur maximale $(N+1)(\Delta V)$. Le générateur 17 comporte pour cela une source de tension continue $E_0$, fournissant une tension $+\Delta V$, connectée de manière fixe au collecteur du transistor 10 et connectable à un ensemble de N sources de tension continue $E_1$ à $E_N$, fournissant chacune une tension $+\Delta V$, et connectables entre elles en série.

La source $E_0$ a son pôle positif relié à la tension de référence (ou masse) et son pôle négatif relié au pôle positif de la source $E_1$ qui a elle-même son pôle négatif connectable au pôle positif de la source $E_2$, au moyen d'un interrupteur $C_1$, et ainsi de suite jusqu'à la source $E_N$ dont le pôle négatif est connectable au moyen d'un interrupteur $C_N$ à l'électrode de polarisation du transistor 10.

Par ailleurs une diode $D_n$ est montée en parallèle sur l'ensemble source $E_n$-interrupteur $C_n$ (n variant de 1 à N), la diode $D_1$ ayant son anode reliée au pôle positif de la source $E_1$ et sa cathode reliée au pôle positif de la source $E_2$, et ainsi de suite jusqu'à la diode $D_N$ qui a son anode reliée au pôle positif de la source $E_N$ et sa cathode reliée à l'électrode de polarisation du transistor 10.

La connexion ou la déconnexion des sources $E_n$ est commandée par un ensemble 18 de N comparateurs permettant de comparer la tension de sortie $s(t)$ à N tensions : $\Delta V$, $2(\Delta V)$, ..., $N(\Delta V)$ et fournissant N signaux de commande $S_1$, $S_2$, ..., $S_N$ qui sont appliqués respectivement aux entrées de commande des interrupteurs $C_1$, $C_2$, ..., $C_N$.

De même une tension de polarisation E' est appliquée à l'émetteur transistor 11. La tension de polarisation E', fournie par un générateur 19, varie graduellement, par paliers de $\pm \Delta V$, à partir d'une valeur fixe $-\Delta V$ et jusqu'à une valeur $-(N+1)\Delta V$. Le générateur 19 comporte pour cela une source de tension continue $E'_0$, fournissant une tension $-\Delta V$, connectée de manière fixe à l'émetteur du transistor 11 et connectable à un ensemble de N sources de tension continue $E'_1$ à $E'_n$, fournissant chacune une tension $-\Delta V$ et connectables entre elles en série. Le générateur 19 comporte également, comme le générateur 17, N interrupteurs $C'_n$ et N diodes $D'_n$, et l'ensemble sources-commutateurs-diodes est monté comme dans le générateur 17, en respectant toutefois le changement de polarité.

La connexion ou la déconnexion des sources $E'_n$ est commandée par un ensemble 20 de N comparateurs permettant de comparer la tension de sortie $s(t)$ à N tensions : $-\Delta V$, $-2(\Delta V)$, ..., $-N(\Delta V)$ et fournissant N signaux de commande $S'_1$, $S'_2$, ..., $S'_N$ qui sont appliqués aux entrées de commande des interrupteurs $C'_1$, $C'_2$, ..., $C'_N$.

Les interrupteurs $C_n$ et $C'_n$ sont réalisés au moyen de transistors fonctionnant en régime de commutation (ouverts ou fermés) dont le rendement est très proche de 1.

Par ailleurs, deux inductances amorties 21 et 22 sont interposées respectivement entre la sortie des générateurs 17 et 19 et l'électrode de polarisation des transistors 10 et 11, de manière à éliminer les variations instantanées des tensions de polarisation E et E' dues aux fronts raides lors de la connexion ou de la déconnexion des sources de tension continue.

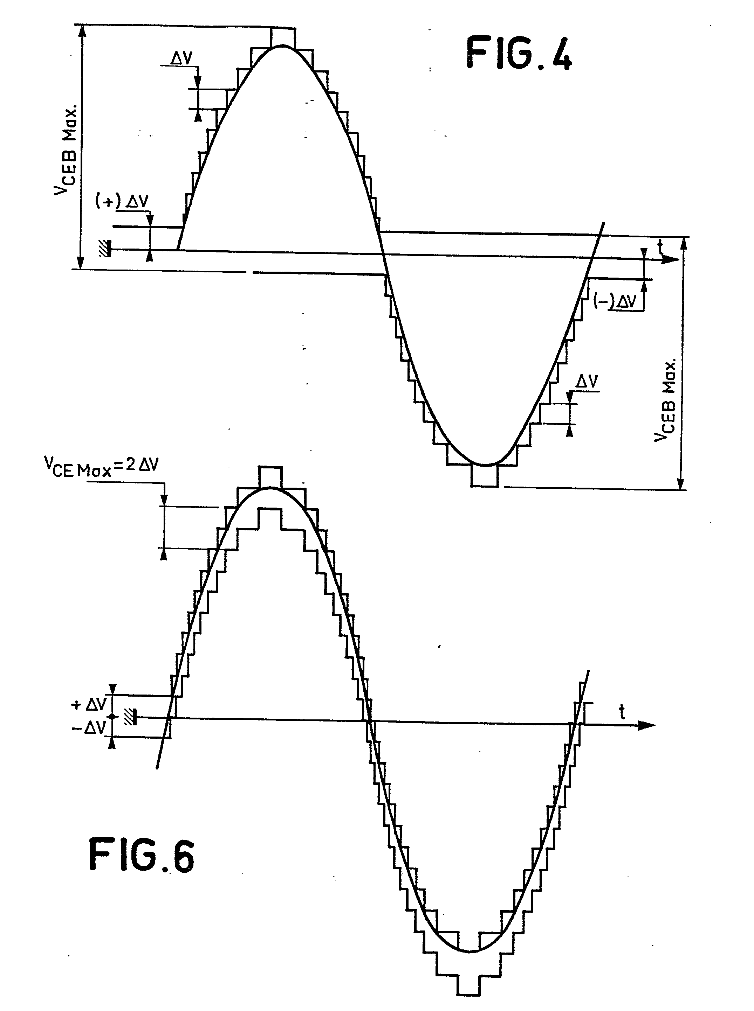

On a représenté sur la figure 4, à titre d'exemple, l'allure de la tension de sortie $s(t)$ et des tensions de polarisation E et E' pour une tension d'entrée $e(t)$ sinusoïdale.

Lors des alternances positives, le transistor 10 est conducteur et le transistor 11 est bloqué, la tension collecteur-émetteur du transistor 10 restant toujours inférieure ou égale à $\Delta V$ quelle que soit l'amplitude de la tension de sortie. La tension de sortie est limitée par la valeur de la tension collecteur-émetteur maximum $V_{CEBmax}$ que peut supporter le transistor 11 bloqué. La tension de sortie $s(t)$ maximale, correspondant à une tension de polarisation E égale à $(N+1)\Delta V$, est égale à $N(\Delta V)$. Les mêmes phénomènes se produisent pendant les alternances négatives, en inversant le rôle des transistors 10 et 11.

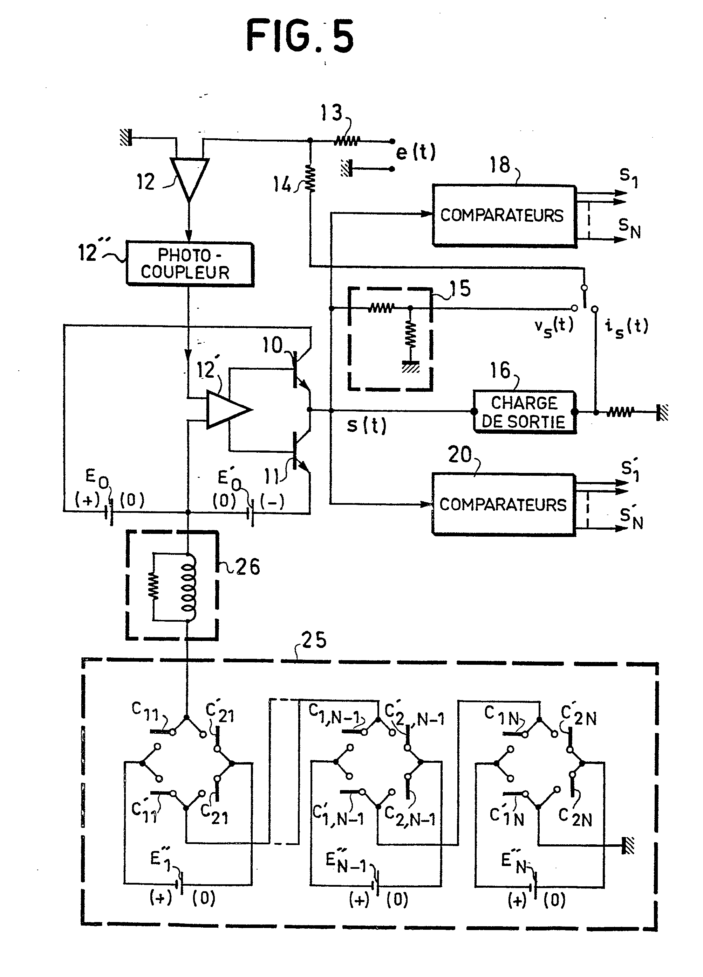

La variante de réalisation représentée sur la figure 5 ne diffère de celle représentée sur la figure 3 que par la réalisation du générateur de tensions de polarisation.

Les deux ensembles de sources de tension continue, positive : $E_1$ à $E_N$, et négative : $E'_1$ à $E'_N$ sont remplacés par un ensemble unique 25 de sources de tension continue $E''_1$ à $E''_N$ fournissant chacune une tension continue de valeur absolue $\Delta V$ et connectables entre elles, en série, suivant deux polarités possibles. A la différence de la figure 3, l'amplificateur de puissance est monté en "flottant". La source $E_0$ fournissant la tension fixe $+ \Delta V$ a son pôle positif relié au collecteur du transistor 10 et la source $E'_0$ fournissant la tension fixe $- \Delta V$ a son pôle négatif relié à l'émetteur du transistor 11.

Le pôle négatif de la source $E_0$ et le pôle positif de la source $E'_0$ sont reliés entre eux et ce point commun est relié d'une part à l'ensemble 25 de sources $E''_n$ via une inductance amortie 26, d'autre part à une des entrées d'un amplificateur 12' de commande des transistors 10 et 11, à gain réduit, l'autre entrée de l'amplificateur 12' étant reliée, via un photocoupleur 12", à la sortie de l'amplificateur 12 à grand gain qui reçoit le signal d'entrée e(t).

Chaque source $E''_n$ peut être connectée à la suivante soit au moyen de deux interrupteurs $C_{1n}$ et $C_{2n}$ si cette connexion doit se faire suivant une polarité positive, soit au moyen de deux interrupteurs $C'_{1n}$ et $C'_{2n}$ si cette connexion doit se faire suivant une polarité négative.

Les interrupteurs $C_{1n}$, $C'_{1n}$, $C_{2n}$ et $C'_{2n}$ sont montés en pont. Le point commun aux interrupteurs $C_{1n}$ et $C'_{2n}$ est relié au point commun aux interrupteurs $C'_{1, n-1}$ et $C_{2, n-1}$, le point commun aux interrupteurs $C_{11}$ et $C'_{21}$ (correspondant à la valeur n égale à 1) étant relié au point commun aux sources d'alimentation fixe $E_0$ et $E'_0$. Le point commun aux interrupteurs $C'_{1n}$ et $C_{2n}$ est relié au point commun aux interrupteurs $C_{1,n+1}$ et $C'_{2,n+1}$, le point commun aux interrupteurs $C'_{1N}$ et $C_{2N}$ (correspondant à la valeur n égale à N) étant mis à la masse. Par ailleurs, le point commun aux interrupteurs $C_{1n}$ et $C'_{1n}$ est relié au pôle positif de la source de tension $E''_n$ et le point commun aux interrupteurs $C_{2n}$ et $C'_{2n}$ est relié au pôle négatif de la source de tension $E''_n$.

Ces interrupteurs sont actionnés de la façon suivante.

Lorsque tous les interrupteurs $C_{1n}$ et $C'_{1n}$ sont ouverts, et lorsque tous les interrupteurs $C_{2n}$ et $C'_{2n}$ sont fermés, la tension fournie par l'ensemble 25 est nulle.

Si, partant de cette situation, on ferme les interrupteurs $C_{11}$ et $C_{21}$ (ceux-ci étant commandés par le signal $S_1$), la tension fournie par l'ensemble 25 passe de 0 à + $\Delta V$, et ainsi de suite jusqu'à $+N(\Delta V)$ lorsqu'on ferme les interrupteurs $C_{1N}$ et $C_{2N}$ (ceux-ci étant commandés par le signal $S_N$). Le processus est le même dans l'ordre inverse, pour déconnecter les sources de tension $E''_n$ et passer graduellement de $+N(\Delta)V$ à 0.

Le processus est également le même pour passer de 0 à $-N(\Delta V)$, puis de $-N(\Delta V)$ à 0, à ceci près que ce sont les interrupteurs $C'_{1n}$ et $C'_{2n}$ qui sont alors actionnés (ces interrupteurs étant commandés par le signal $S'_n$).

Tous ces interrupteurs sont en pratique réalisés au moyen de transistors utilisés en régime de commutation.

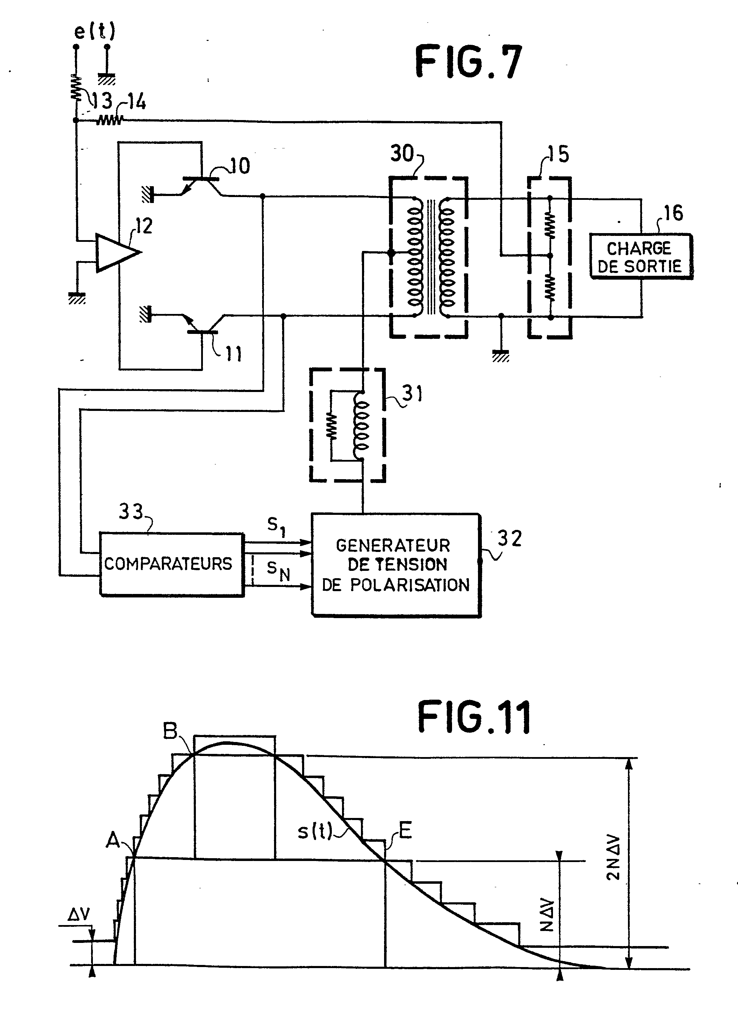

On a représenté sur la figure 6 l'allure de la tension de sortie s(t) pour une tension d'entrée e(t) sinusoïdale ainsi que l'allure des tensions de polarisation E et E' des transistors 10 et 11. Au cours de la polarité positive, le transistor 10 est conducteur tandis que le transistor 11 est bloqué. Lorsque la tension de sortie s(t) augmente, la tension de polarisation E du transistor 10 augmente par paliers successifs de $\Delta V$ suivant le processus décrit précédemment. A chaque commutation d'une alimentation positive, la tension de polarisation E' du transistor 11 augmente également, avec un décalage de $2(\Delta V)$ puisque l'électrode de polarisation du transistor 11 est reliée aux alimentations commandables par le point commun aux alimentations fixes $E_0$ et $E'_0$. Il en est de même au cours de la polarité négative, le transistor 11 étant bloqué tandis que le transistor 10 est conducteur. Suivant ce mode de réalisation, la tension collecteur-émetteur de celui des transistors 10 et 11 qui est bloqué est au plus égale à $2(\Delta V)$.

Ce montage permet donc d'obtenir une tension de sortie qui n'est pas limitée par la tension $V_{CEBMax}$ des transistors. Ainsi, avec le nombre d'alimentations $\Delta V$ nécessaires, ce montage fournit une tension de sortie aussi élevée que désiré.

Dans la variante de réalisation représentée sur la figure 7, il est prévu un transformateur à point milieu 30 dont l'enroulement primaire est relié d'une part au collecteur du transistor 10, d'autre part au collecteur du transistor 11 (l'émetteur des transistors 10 et 11 étant mis à une tension de référence, ou masse), et dont l'enroulement secondaire est relié à la charge de sortie 16. Le point milieu de l'enroulement primaire est relié via une inductance amortie 31 à un générateur 32 de tension de polarisation comportant une seule source d'alimentation fixe et un seul ensemble de sources de tension d'alimentation commandables par un ensemble de comparateurs 33 qui reçoit les signaux obtenus au collecteur des transistors 10 et 11.

L'amplificateur de commande 12 et la charge de sortie 16 sont référencés par rapport à la masse et la présence du transformateur permet d'obtenir une tension de sortie aussi élevée que désiré. En revanche, ce montage ne permet pas d'obtenir des signaux de sortie de forme dissymétrique ou symétrique avec un "offset". De plus, la tension de polarisation des transistors est limitée à la moitié de la tension collecteur-émetteur maximale de ces derniers (à cause du transformateur à point milieu).

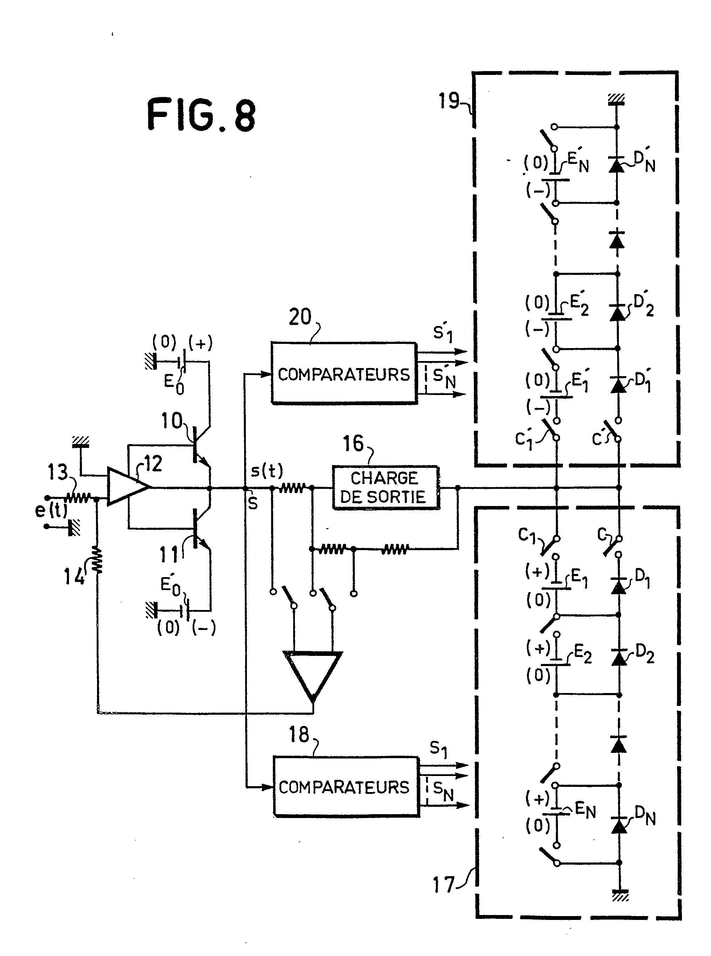

La variante de réalisation représentée sur la figure 8 s'apparente à celle qui est représentée sur la figure 3, mais se distingue de celle-ci par le fait qu'au collecteur du transistor 10 et à l'émetteur du transistor 11 sont connectés uniquement les sources de tension fixe $E_0$ et $E'_0$, les deux ensembles 17 et 19 de sources de tension commandables ($E_n$, $D_n$, $C_n$) et ($E'_n$, $D'_n$, $C'_n$) étant disposés en sortie des transistors, deux interrupteurs C et C' (commandés respectivement comme les interrupteurs $C_1$ et $C'_1$) étant alors prévus pour connecter les diodes $D_1$ et $D'_1$ en sortie des transistors.

A l'inverse des modes de réalisation décrits précédemment, mais pour obtenir le même effet, à savoir maintenir la tension collecteur-émetteur de celui des transistors 10 et 11 qui conduit, inférieure ou égale à $\Delta V$ en valeur absolue, les alimentations commandables $+ \Delta V$ sont alors commandées pendant les alternances positives du signal e(t) et les alimentations commandables $- \Delta V$ sont commandées pendant les alternances négatives.

Dans ce montage, l'amplificateur de puissance est piloté par rapport à la masse (donc non flottant) et la charge de sortie est flottante. La tension de sortie est limitée à la tension maximale collecteur-émetteur des transistors de commutation C, C', $C_1$, $C'_1$).

10

Les deux ensembles 17 et 19 de sources de tension commandables peuvent être remplacés, comme dans le cas de la figure 5, par un ensemble unique de sources de tension connectables entre elles suivant deux polarités différentes. Dans ce cas la tension de sortie n'est pas limitée.

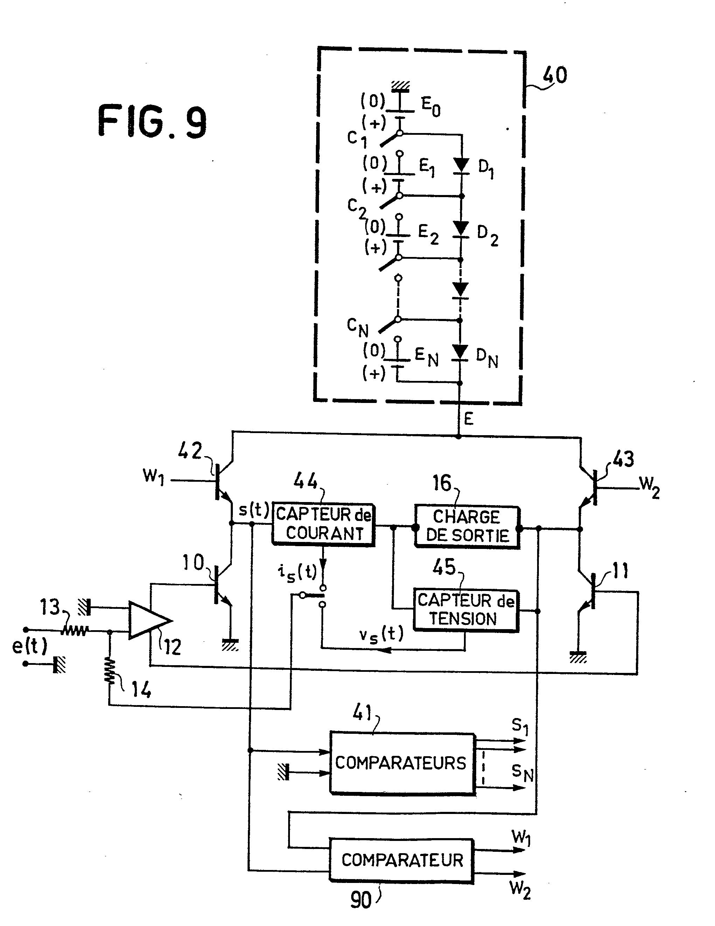

Comme dans le cas de la figure 7, le montage de la figure 9 comporte un seul ensemble 40 de sources de tension continue et un seul ensemble 41 de comparateurs de commande de connexion ou de déconnexion de ces sources.

Ceci est rendu possible par la présence de deux transistors 42 et 43 fonctionnant en commutation, l'un étant conducteur quand l'autre est bloqué, et vice versa, permettant d'appliquer la tension de polarisation E fournie par l'ensemble 40 de sources d'alimentation soit telle quelle, soit inversée, à l'amplificateur de puissance. La tension E est appliquée au collecteur des transistors 42 et 43. L'émetteur des transistors 42 et 43 est relié respectivement au collecteur des transistors 10 et 11, l'émetteur des transistors 10 et 11 étant relié à la masse.

Sur la base des transistors 42 et 43 sont appliqués respectivement des signaux $w_1$ et $w_2$ fournis par un comparateur 90 qui détecte le changement de sens du courant dans la charge de sortie 16.

La charge de sortie 16 est disposée entre le collecteur du transistor 10 et le collecteur du transistor 11. En série avec la charge de sortie et en parallèle avec celle-ci sont disposés respectivement des capteurs de courant, 44, et de tension, 45, fournissant respectivement le courant de contre-réaction $i_s(t)$ et la tension de contre-réaction $v_s(t)$.

Dans ce montage, l'amplificateur de puissance est piloté par rapport à la masse, la charge de sortie est flottante, et la tension de sortie est limitée à la tension maximale collecteur-émetteur de l'amplificateur de puissance.

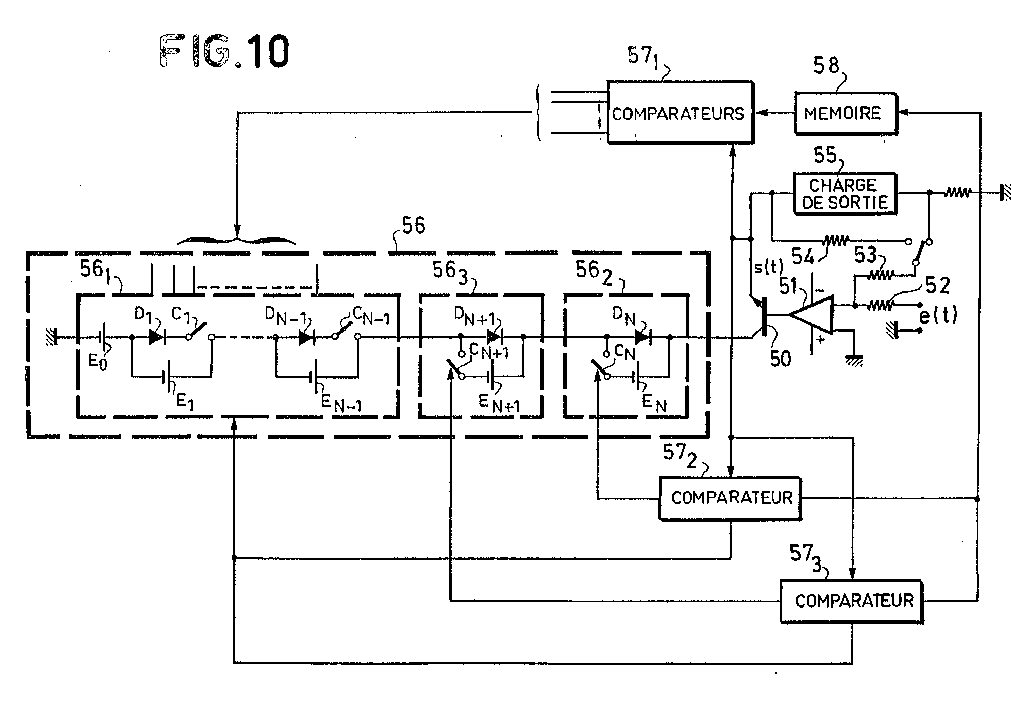

Sur la figure 10 on a représenté un autre mode de réalisation de l'invention s'appliquant, à titre d'exemple, à un amplificateur comportant un seul transistor 50 du type classe B.

Comme précédemment, la base, ou électrode de commande, de ce transistor est reliée à la sortie d'un amplificateur 51 à très grand gain dont l'entrée reçoit d'une part le signal à amplifier e(t), via une résistance 52, d'autre part un signal de contre-réaction, via une résistance 53. Le signal de

11

contre-réaction est soit le courant de sortie $i_s(t)$, soit la tension $v_s(t)$ obtenue aux bornes d'une résistance 54 disposée en sortie du transistor.

L'amplificateur 51 est alimenté ; l'alimentation de cet amplificateur est au moins égale à la tension maximum que l'on désire et est donc fonction du nombre d'alimentations commandables. Cette remarque s'applique également aux amplificateurs de commande intervenant dans les montages précédents.

Une charge de sortie 55 est connectée à l'émetteur, ou électrode de sortie du transistor 50.

Au collecteur, ou électrode de polarisation du transistor 50, est appliquée une tension de polarisation E fournie par un générateur 56 de tension de polarisation variable par paliers de $\pm \Delta V$ à partir d'une valeur fixe $\Delta V$, et jusqu'à une valeur maximale égale en l'occurrence à $3N(\Delta V)$, mais de manière plus générale à $MN(\Delta V)$ (avec M entier), au lieu de $N(\Delta V)$ comme c'était le cas avec les montages précédents, et ceci sans accroître de manière prohibitive le nombre de sources de tension élémentaires $\Delta V$ par rapport aux montages précédents.

Pour cela le générateur 56 comporte un premier module $56_1$ consistant en une source de tension continue $E_0$ fournissant une tension $\Delta V$, connectée au collecteur du transistor 50 et connectable en série à un ensemble de N-1 sources de tension continue $E_1$ à $E_{N-1}$ elles-mêmes connectables entre elles en série et fournissant chacune un échelon de tension $\Delta V$.

Le générateur 56 comporte également un second module $56_2$ consistant en une source de tension continue $E_N$ connectable en série aux sources $E_0$ à $E_{N-1}$ et fournissant un échelon de tension égal à $N(\Delta V)$, et un troisième module $56_3$ consistant en une source de tension continue $E_{N+1}$ connectable en série aux sources $E_0$ à $E_N$ et fournissant un échelon de tension égal à $2N(\Delta V)$.

Les sources $E_N$ et $E_{N+1}$ sont connectables au moyen d'interrupteurs $C_N$ et $C_{N+1}$ ; des diodes $D_N$ et $D_{N+1}$ sont prévues pour court-circuiter ces sources lorsqu'elles ne sont pas en service.

Comme dans les montages précédents, les interrupteurs $C_1$ à $C_{N-1}$, permettant la mise en service des sources $E_1$ à $E_{N-1}$ du module $56_1$ sont commandés par un ensemble de comparateurs $57_1$ permettant de comparer

la tension de sortie amplifiée à N-1 tensions de seuil $S_1$ à $S_{N-1}$ initialement égales respectivement à $\Delta V$, $2(\Delta V)$, ..., $(N-1)\Delta V$ et mémorisées dans une mémoire de seuils de comparaison 58. Les interrupteurs $C_1$ à $C_{N-1}$ sont également commandés, ainsi que l'interrupteur $C_N$, par un comparateur $57_2$ permettant de comparer la tension de sortie amplifiée $s(t)$ à la tension $N(\Delta V)$. Lorsque la tension de sortie $s(t)$ devient égale à $N(\Delta V)$, l'interrupteur $C_N$ est fermé et les interrupteurs $C_1$ à $C_{N-1}$ sont simultanément ouverts, portant ainsi la tension de polarisation à une valeur $(N+1)\Delta V$. De plus, la valeur $N(\Delta V)$ est ajoutée aux valeurs initiales des seuils de comparaison $S_1$ à $S_{N-1}$.

Les interrupteurs $C_1$ à $C_N$ sont également commandés, ainsi que l'interrupteur $C_N$, par un comparateur $57_3$ permettant de comparer la tension de sortie amplifiée $s(t)$ à la tension $(N+1)\Delta V$. Lorsque la tension de sortie $s(t)$ devient égale à $(N+1)\Delta V$, l'interrupteur $C_{N+1}$ est fermé, et les interrupteurs $C_1$ à $C_N$ sont simultanément ouverts, portant ainsi la tension de polarisation à une valeur $(2N+1)\Delta V$. De plus, la valeur $N(\Delta V)$ est à nouveau ajoutée aux valeurs des seuils de comparaison $S_0$ à $S_{N-1}$.

La figure 11 illustre de manière plus concrète le fonctionnement de l'amplificateur représenté sur la figure 10.

Tant que le signal de sortie $s(t)$ de l'amplificateur classe B n'atteint pas une amplitude égale à $N(\Delta V)$ (point A), les deux alimentations supplémentaires $E_N$ et $E_{N+1}$ sont déconnectées et le courant passe par les diodes.

Lorsque le signal $s(t)$ atteint le point A, toutes les alimentations $E_1$ à $E_{N-1}$ sont connectées, le comparateur $57_2$ ferme l'interrupteur $C_N$ de l'alimentation $E_N$ égale à $N(\Delta V)$, déconnecte toutes les alimentations $E_1$ à $E_{N-1}$ et ajoute aux valeurs de seuil de comparaison précédentes la valeur $N(\Delta V)$.

Lorsque le signal $s(t)$ vaut $(N+1)\Delta V$, le comparateur de l'ensemble $57_1$ dont le seuil est $(N+1)\Delta V$ (précédemment $\Delta V$) met en fonction une alimentation $\Delta V$ de l'ensemble $56_1$.

Le processus se poursuit jusqu'à $2N(\Delta V)$ (point B) où comme précédemment le comparateur $57_3$ exerce trois fonctions : fermeture de l'alimentation $E_{N+1}$ égale à $2N(\Delta V)$, déconnexion de toutes les alimentations $E_1$ à $E_{N-1}$ de l'ensemble $56_1$ et addition de $N(\Delta V)$ aux valeurs de seuil de comparaison.

Lorsque le signal à amplifier décroît, les opérations inverses sont effectuées.

Comme dans la variante de réalisation décrite précédemment en relation avec la figure 8, les alimentations supplémentaires peuvent être mises en sortie de l'amplificateur.

14

R E V E N D I C A T I O N S :

1. Amplificateur de puissance, linéaire, comportant au moins un transistor bipolaire (1) de type classe B muni d'une électrode dite de commande, à laquelle est appliqué le signal à amplifier (e(t)) et de deux électrodes dites de transfert, sur l'une desquelles est obtenu le signal amplifié s(t), et des moyens de polarisation (3) de ces transistors, caractérisé en ce que ces derniers comportent un générateur (7) de signaux de polarisation variables par paliers, et des moyens (8) de commande de ce générateur en fonction de l'amplitude du signal amplifié, en vue de maintenir à chaque instant la tension entre électrodes de transfert, en valeur absolue, de celui des transistors qui est conducteur à cet instant, au plus égale à une valeur limite $\Delta V$.

2. Amplificateur selon la revendication 1, caractérisé en ce que les paliers sont de valeur égale.

3. Amplificateur selon la revendication 1, caractérisé en ce que les paliers ont de valeur inégale.

4. Amplificateur selon la revendication 1, et comportant deux transistors (10, 11) du type classe B dont l'un conduit pendant les alternances positives du signal à amplifier, l'autre pendant les alternances négatives, dans lequel chacun des transistors est muni d'une première électrode de transfert constituant l'électrode de sortie et d'une seconde électrode de transfert, caractérisé en ce que le générateur (17, 19) de signaux de polarisation variables par paliers comporte deux sources de tension continue $E_0$ et $E'_0$ connectées respectivement à la seconde électrode de transfert de l'un des transistors et connectables en série respectivement à deux ensembles de N sources de tension continue $E_n$ et $E'_n$ (n variant de 1 à N) elles-mêmes connectables entre elles en série, les sources $E_n$ et $E'_n$ (n variant de 0 à N) fournissant respectivement des tensions continues $+\Delta V$ et $-\Delta V$, ce qui permet de maintenir la tension entre électrodes de transfert (en valeur absolue) de celui des transistors qui est conducteur au plus égale à $\Delta V$.

5. Amplificateur selon la revendication 4, caractérisé en ce que les

15

deux ensembles de sources de tension continue $E_n$ et $E'_n$ sont remplacés par un seul ensemble (25) de N sources de tension continue $E''_n$ (n variant de 1 à N), fournissant chacune une tension continue de valeur absolue $\Delta V$ et connectables entre elles, en série, suivant deux polarités possibles, ce qui permet de maintenir la tension collecteur-émetteur (en valeur absolue) de celui des transistors qui est conducteur au plus égale à $\Delta V$, et celle de celui des transistors qui est bloqué, au plus égale à $2(\Delta V)$.

6. Amplificateur selon l'une des revendications 4 et 5, caractérisé en ce que les moyens de commande du générateur de tensions de polarisation comportent deux ensembles (18, 20) de N comparateurs pour comparer la tension de sortie de l'amplificateur respectivement aux tensions $n(\Delta V)$ et $-n(\Delta V)$ (n variant de 1 à N), et pour commander soit l'augmentation de $\Delta V$, soit la diminution de $\Delta V$, de la tension de polarisation appliquée à la seconde électrode de transfert de celui des transistors qui est conducteur, suivant que la tension de sortie de l'amplificateur augmente ou diminue de $\Delta V$.

7. Amplificateur selon la revendication 1, dans lequel chacun des transistors est muni d'une première électrode de transfert constituant l'électrode de sortie et d'une seconde électrode de transfert, caractérisé en ce que le générateur de signaux de polarisation variables par paliers comporte deux sources de tension continue $E_0$ et $E'_0$ connectées respectivement à la seconde électrode de transfert de l'un des transistors, et deux ensembles (17, 19) de N sources de tension continue $E_n$ et $E'_n$ (n variant de 1 à N) elles-mêmes connectables entre elles en série, et connectables à la première électrode de transfert, ou électrode de sortie commune des transistors, les sources $E_n$ et $E'_n$ (n variant de 0 à N) fournissant respectivement des tensions continues $+\Delta V$ et $-\Delta V$.

8. Amplificateur selon la revendication 7, caractérisé en ce que les deux ensembles de N sources de tension continue $E_n$ et $E'_n$ sont remplacés par un seul ensemble de N sources de tension continue fournissant chacune une tension de valeur absolue $\Delta V$, et connectables entre elles, en série, suivant deux polarités possibles.

9. Amplificateur selon l'une des revendications 7 et 8, caractérisé en ce que les moyens de commande du générateur de signaux de polarisation comportent deux ensembles (18, 20) de N comparateurs pour comparer la tension de sortie de l'amplificateur respectivement aux tensions n( $\Delta$V) et - n( $\Delta$V) (n variant de 1 à N), et pour commander soit l'augmentation de $\Delta$V, soit la diminution de $\Delta$V, de la tension de polarisation appliquée à la première électrode de transfert, ou électrode de sortie, de celui des transistors qui est conducteur, suivant que la tension de sortie de l'amplificateur diminue ou augmente de $\Delta$V.

10. Amplificateur selon la revendication 1, dans lequel chacun des transistors est muni d'une première électrode de transfert constituant l'électrode de sortie, et d'une seconde électrode de transfert mise à la tension de référence, caractérisé en ce que le générateur de (32) signaux de polarisation variables par paliers comporte une seule source de tension continue connectée au point milieu de l'enroulement primaire d'un transformateur (30), et connectable en série à un seul ensemble de N sources de tension continue elles-mêmes connectables entre elles en série, les extrémités de l'enroulement primaire étant connectées respectivement à l'électrode de sortie de l'un des transistors, et le signal de sortie amplifié étant obtenu aux bornes de l'enroulement secondaire du transformateur.

11. Amplificateur selon la revendication 1, dans lequel chacun des transistors est muni d'une première électrode de transfert constituant l'électrode de sortie, et d'une seconde électrode de transfert mise à la tension de référence, caractérisé en ce que le générateur (40) de signaux de polarisation variables par paliers comporte une seule source de tension continue connectée à une extrémité commune à deux interrupteurs (42, 43) et connectable en série à un seul ensemble de N sources de tension continue elles-mêmes connectables entre elles en série, l'un des interrupteurs étant ouvert pendant les alternances positives du signal à amplifier, et l'autre étant fermé, et vice versa pendant les alternances négatives, l'autre extrémité de ces interrupteurs étant reliée respectivement à l'électrode de sortie de l'un des transistors.

12. Amplificateur selon la revendication 1, caractérisé en ce que le générateur de signaux de polarisation variables par paliers comporte, suivant que l'amplificateur comporte un ou deux transistors de type classe B, un ou deux ensembles (56) formés d'une part d'un premier module ($56_1$) qui

comporte une source de tension continue fournissant une tension ΔV, connectée à l'une des électrodes de transfert de l'un des transistors, et connectables en série à N-1 sources de tension continue elles-mêmes connectables entre elles en série, et d'autre part de M modules (56m) connectables en série au premier module et connectables entre eux en série, chacun d'eux comportant une source de tension continue fournissant une tension continue mN( ΔV) (m variant de 1 à M).

13. Amplificateur selon la revendication 12, caractérisé en ce que les moyens de commande du générateur de signaux de polarisation variables par paliers comportent au moins un ensemble formé d'une part de N-1 comparateurs ($57_1$) pour comparer la tension amplifiée à N-1 tensions de seuil initialement égales, en valeur absolue, à n( ΔV) (n variant de 1 à N-1), d'autre part de M comparateurs (57m) pour comparer la tension amplifiée à M tensions de seuil initialement égales, en valeur absolue, à m( ΔV) (m variant de 1 à M), et des moyens pour augmenter, ou diminuer, la valeur des tensions de seuil de la valeur N( ΔV) à chaque connexion, ou déconnexion, d'une des M sources de tension continue.

0147306

# FIG.1

GENERATEUR
DE TENSION
DE
POLARISATION

COMPARATEURS

CHARGE
DE SORTIE

# FIG.2

FIG.3

# FIG.4

# FIG.6

0147306

# FIG.5

0147306

5/8

# FIG.7

CHARGE DE SORTIE

COMPARATEURS

GENERATEUR DE TENSION DE POLARISATION

# FIG.11

0147306

# FIG.8

FIG. 9

7/8

0147306

FIG.10

0147306